# EUROPÄISCHE PATENTSCHRIFT

(11) **EP 1 859 073 B1**
(45) Veröffentlichungstag und Bekanntmachung des Hinweises auf die Patenterteilung: **11.07.2018**
(21) Anmeldenummer: 06701163.5
(22) Anmeldetag: 25.01.2006
(51) Int. Cl.: C23C 16/24, C23C 16/44, H01M 4/133, H01M 4/36, H01M 4/587, H01M 10/0525, H01M 4/38

(54) **VERFAHREN ZUR HERSTELLUNG VON BESCHICHTETEN KOHLENSTOFFPARTIKELN UND DEREN VERWENDUNG IN ANODENMATERIALIEN FÜR LITHIUM-IONENBATTERIEN**
METHOD FOR PRODUCING COATED CARBON PARTICLES AND USE OF THE LATTER IN ANODE MATERIALS FOR LITHIUM-ION BATTERIES
PROCEDE DE PRODUCTION DE PARTICULES DE CARBONE ENROBEES, ET LEUR UTILISATION DANS DES MATERIAUX ANODIQUES POUR DES BATTERIES AU ION-LITHIUM

(30) Priorität: 14.03.2005 DE 102005011940
(43) Veröffentlichungstag der Anmeldung: 28.11.2007
(73) Patentinhaber: Litarion GmbH, 01917 Kamenz (DE)
(72) Erfinder: PETRAT, Frank-Martin, 48151 Münster (DE); WIGGERS, Hartmut, 48734 Reken (DE); REEKEN, Burkhard, 46284 Dorsten (DE); HOLZAPFEL, Michael, 80992 München (DE); BUQA, Hilmi, 5200 Brugg (CH); NOVÁK, Petr, 5200 Brugg (CH)
(74) Vertreter: Tostmann, Holger Carl
(86) Internationale Anmeldenummer: PCT/EP2006/050438
(87) Internationale Veröffentlichungsnummer: WO 2006/097380

(56) Entgegenhaltungen:
- WO-A-2005/096414
- GB-A- 1 228 253
- US-A- 3 617 347
- US-A- 5 277 940
- PATENT ABSTRACTS OF JAPAN Bd. 2003, Nr. 12, 5. Dezember 2003 (2003-12-05) -& JP 2004 182512 A (SHOWA DENKO KK), 2. Juli 2004 (2004-07-02)
- HASEGAWA T ET AL: "Preparation of carbon gel microspheres containing silicon powder for lithium ion battery anodes" CARBON, Bd. 42, Nr. 12-13, 2004, Seiten 2573-2579, XP004526567 ISSN: 0008-6223

## Beschreibung

Die Erfindung betrifft ein Verfahren zur Herstellung von beschichteten Kohlenstoffpartikel, die beschichteten Kohlenstoffpartikel sowie deren Verwendung zur Herstellung von Anodenmaterial für Lithium-Ionenbatterien.

Lithium-Ionenbatterien sind technisch sehr interessante Energiespeichersysteme, da sie unter den bekannten, praktisch verwendbaren chemischen und elektrochemischen Energiespeichern die höchste Energiedichte von bis zu 180 Wh/kg aufweisen. Ihre Anwendung finden die Lithium-Ionenbatterien vor allem im Bereich der tragbaren Elektronik, wie beispielsweise Laptops oder Mobiltelefonen, sogenannten Handys. Auch eine Anwendung der Lithium-Ionenbatterien im Bereich der Fortbewegungsmittel, wie beispielsweise Fahrräder oder Automobile, wird bereits diskutiert.

Als negatives Elektrodenmaterial ("Anode") findet vor allem graphitischer Kohlenstoff seine Anwendung. Der graphitische Kohlenstoff zeichnet sich durch seine stabilen Zykleneigenschaften und seine, im Vergleich zu Lithiummetall, das in so genannten "Lithiumbatterien" zum Einsatz kommt, recht hohe Handhabungssicherheit aus. Ein wesentliches Argument für die Verwendung von graphitischem Kohlenstoff in negativen Elektrodenmaterialien liegt in den geringen Volumenänderungen des Wirtsmaterials, die mit der Ein- und Auslagerung von Lithium verbunden sind, d.h. die Elektrode bleibt annähernd stabil. So lässt sich für die Lithiumeinlagerung in graphitischem Kohlenstoff nur eine Volumenzunahme von ca. 10 % für die Grenzstöchiometrie von LiC₆ messen. Ein Nachteil des graphitischen Kohlenstoffs ist hingegen seine relativ niedrige elektrochemische Kapazität von theoretisch: 372 mAh/g Graphit, die etwa nur ein Zehntel, der mit Lithiummetall theoretisch erreichbaren elektrochemischen Kapazität von 3862 mAh/g Lithium entspricht.

Seit langem wird deshalb nach alternativen Materialien geforscht, v.a. im Bereich der Legierungen, wie beispielsweise binären Legierungen auf der Basis von Aluminium (Lindsay et al. in J. Power Sources 119 (2003), 84), Zinn (Winter et al. in Electrochim. Acta 45 (1999), 31; Tirado in Mater. Sci. Eng. R-Rep. 40 (2003), 103) oder Antimon (Tirado in Mater. Sci. Eng. R-Rep. 40 (2003), 103), ternären Legierungen auf der Basis von Kupfer-Zinn (Kepler et al. in Electrochem Solid-State Lett 2 (1999), 307) oder Kupfer-Antimon (Yang et al. in Electrochem. Solid State Lett. 2 (1999), 161) oder Metalloxiden auf der Basis von Zinnoxid (Huggins in Solid State Ion. 152 (2002), 61). Diese Materialien haben hohe theoretische spezifische Kapazitäten von beispielsweise 994 mAh/g im Falle von Zinn. Könnte man diese hohen theoretischen Kapazitäten reversibel nutzen, wäre eine deutliche Erhöhung der Energiedichte von Lithium-Ionenbatterien möglich.

Anodenmaterialien auf der Basis von Legierungen bieten im Vergleich zu metallischem Lithium den Vorteil, dass es nicht zur Dendritenbildung bei der Lithiumabscheidung kommt. Im Gegensatz zu Graphitmaterialien eignen sich Anodenmaterialien auf der Basis von Legierungen für den Einsatz zusammen mit Elektrolyten auf der Basis von Propylencarbonat. Dies ermöglicht die Anwendung von Lithium-Ionenbatterien bei niedrigen Temperaturen. Der Nachteil dieser Legierungen ist allerdings die große Volumenausdehnung während des Zyklens - also während des Ein- und Auslagerns des Lithiums, die über 200 % teilweise sogar bis zu 300 % beträgt (Besenhard et al. in J. Power Sources 68 (1997), 87).

Silizium wurde ebenfalls erforscht, weil es ähnlich wie Zinn, mit Lithium binäre Verbindungen bildet, die elektrochemisch aktiv sind (Weydanz et al. in Journal of Power Sources 82 (1999), 237; Seefurth et al. in J. Electrochem. Soc. 124 (1977), 1207; Lai in J. Electrochem. Soc. 123 (1976), 1196). Diese binären Verbindungen von Lithium und Silizium weisen einen sehr hohen Lithiumgehalt auf. Das theoretische Maximum an Lithiumgehalt findet man bei Li_{4.2}Si, dies entspricht einer sehr hohen theoretischen spezifischen Kapazität von ca. 4400 mAh/g Silizium (Lupu et al. in Inorg. Chem. 42 (2003), 3765). Diese binären Verbindungen bilden sich bei einem ähnlich niedrigen Potential wie die Einlagerungsverbindungen von Lithium in Graphit bei < 500 mV vs. Li/Li⁺ (d.h. gegenüber dem Potential von metallischem Lithium, welches als Referenz dient). Wie bei den oben genannten binären Legierungen ist auch im Falle des Siliziums die Ein- und Auslagerung von Lithium mit einer sehr starken Volumenausdehnung verbunden, die bei maximal 323 % liegt. Diese Volumenausdehnung führt zu einer starken mechanischen Belastung der Kristallite und dadurch zu einer Amorphisierung und einem Auseinanderbrechen der Partikel unter Verlust des elektrischen Kontakts (Winter et al. in Adv. Mater. 10 (1998), 725; Yang et al. in Solid State Ion. 90 (1996), 281; Bourderau et al. in J. Power Sources 82 (1999), 233). Diese mechanische Belastung wirkt sich besonders stark auf den ersten Zyklus aus, während dem eine sehr hohe irreversible Kapazität auftritt (bis über 50%), was den Einsatz des Materials als negative Elektrode bislang unmöglich gemacht hat.

Um die Haftung des Siliziums am Trägermaterial zu verbessern, werden verschiedene Techniken eingesetzt, wie beispielsweise mehrstündiges intensives Vermahlen (Dimov et al. in Electrochim. Acta 48 (2003), 1579; Niu et al. in Electrochem. Solid State Lett. 5 (2002), A107), Carbon-Coating aus der Gasphase (Wilson et al. in J. Electrochem. Soc. 142 (1995), 326), und Pyrolyse eines innigen Gemischs der jeweiliger Precursoren (Larcher et al. in Solid State Ion. 122 (1999), 71; Wen et al. in Electrochem. Commun 5 (2003), 165). Dabei wird sowohl mit siliziumreichen (60-80 Gew.-% Si), als auch siliziumarmen (5-20 Gew.-% Si) Formulierungen experimentiert.

Experimente mit nanoskaligen Materialien, d. h. einer Partikelgröße von ca. 100 nm, beschreiben Graetz et al. in Electrochem. Solid State Lett. 6 (2003), A194; Li et al. in Electrochem. Solid State Lett. 2 (1999), 547, Yang et al. in Electrochem. Solid State Lett. 6 (2003), A154 und Gao et al. in Adv. Mater. 13 (2001), 816. Graetz et al. beschreiben die Darstellung von nanoskaligen Siliziumfilmen, welche eine reversible Kapazität von mehr als 2300 mAh/g (im Falle eines mittels Chemical Vapor Deposition abgeschiedenen Films) bzw. 1100 mAh/g (im Falle des auf Partikeln aufbauenden Films) zeigen, allerdings ist das Fading relativ hoch. Li et al. benutzen ein Gemisch aus nanoskaligem Silizium und Ruß, welches ebenfalls eine sehr hohe Kapazität von anfänglich bis über 2000 mAh/g zeigt, die allerdings über das Zyklen deutlich abfällt und es sind weniger als 25 Zyklen gezeigt. Yang et al. benutzen die Pyrolyse eines nano-Silizium-haltigen Ausgangsgemisches zur Herstellung ihrer aktiven Materialien und erhalten reversible Kapazitäten von über 700 mAh/g während 30 Zyklen, aber auch hier konnte das Fading nicht vermieden werden. Gao et al. beschreiben die elektrochemische Reaktion von durch Laserablation erhaltenem Silizium mit Lithium, erhalten aber eine reversible Kapazität von anfänglich um die 700 mAh/g.

US3617347 offenbart ein Verfahren zur Herstellung von beschichteten Kohlenstoffpartikeln, wobei Diamantenpartikel in einem Reaktionsraum durch chemische Gasphasenabscheidung aus zumindest einem gasförmigen Silan in einer sauerstofffreiem Gasatmosphäre mit elementarem Silizium beschichtet werden wobei die Partikel während der Gasphasenabscheidung ständig in Bewegung sind.

JP2004182512 offenbart ein mit Silizium beschichteter Kohlenstoffpartikel, z.B. ein Graphitpartikel, Anodenmaterial daraus und dessen Verwendung für Lithium-Ionenbatterien. Die BET ist unter 3g/m2.

Es war deshalb die Aufgabe der vorliegenden Erfindung ein Anodenmaterial für Lithium-Ionenbatterien zur Verfügung zu stellen, das sich durch eine erhöhte mechanische Stabilität während des Zyklens und einer hohen spezifischen Kapazität auszeichnet.

Überraschenderweise wurde gefunden, dass Anodenmaterial, das mit elementarem Silizium beschichtete elektrisch leitfähige Kohlenstoffpartikel aufweist, eine höhere mechanische Stabilität während des Zyklens aufweist als siliziumhaltiges Anodenmaterial gemäß dem Stand der Technik. Das erfindungsgemäße Anodenmaterial zeigt im ersten Zyklus einen geringeren irreversiblen Kapazitätsverlust. Weiterhin zeigt das erfindungsgemäße Anodenmaterial ein geringeres Fading, womit die Zyklendauer erhöht wird. Dadurch ist es möglich, die Vorteile des Siliziums, nämlich dessen sehr hohe spezifische Kapazität ohne die üblicherweise beobachtete Degradation durch mechanische Zerstörung aufgrund der Volumenausdehnung, auszunutzen. Durch den Einsatz der erfindungsgemäßen beschichteten Kohlenstoffpartikel kann die Kapazität von Lithium-Ionenbatterien deutlich gesteigert werden. Dies ermöglicht bei gleicher Geometrie der Zellen in den Lithium-Ionenbatterien eine Verlängerung der Betriebsdauer elektrischer Geräte zwischen zwei Ladevorgängen. Für den Benutzer solcher Geräte mit Lithium-Ionenbatterien, die ein erfindungsgemäßes Anodenmaterial aufweisen, ergibt sich unmittelbar ein höherer Komfort bedingt durch eine größere Unabhängigkeit vom elektrischen Netz. Ein weiterer Vorteil liegt in der Möglichkeit bei konstanter Kapazität der Zellen der Lithium-Ionenbatterie diese zu verkleinern, um so zu kleineren elektrischen Geräten zu gelangen. Damit werden Anwendungsfelder erschlossen, die bisher aufgrund der Größe der entsprechenden Zellen der Lithium-Ionenbatterie nicht zugänglich waren.

Gegenstand der Erfindung ist ein Verfahren zur Herstellung von beschichteten Kohlenstoffpartikel nach Anspruch 1, so dass elektrisch leitfähige Kohlenstoffpartikel in einem Reaktionsraum durch chemische Gasphasenabscheidung aus zumindest einem gasförmigen Silan in einer sauerstofffreien Gasatmosphäre mit elementarem dotiertem oder undotiertem Silizium beschichtet werden, wobei die elektrisch leitfähigen Kohlenstoffpartikel während der Gasphasenabscheidung ständig in Bewegung sind.

Weiterer Gegenstand dieser Erfindung sind beschichtete nach Anspruch 10, so dass ein elektrisch leitfähiger Kohlenstoffkern mit elementarem dotiertem oder undotiertem Silizium beschichtet ist, sowie deren Verwendung zur Herstellung von Anodenmaterial für Lithium-Ionenbatterien.

Ferner ist Gegenstand der Erfindung ein Anodenmaterial für Lithium-Ionenbatterien, das sich dadurch auszeichnet, dass das Anodenmaterial erfindungsgemäße beschichtete Kohlenstoffpartikel aufweist, sowie eine Lithium-Ionenbatterie, die eine Anode bestehend aus einem erfindungsgemäßen Anodenmaterial aufweist.

Das erfindungsgemäße Verfahren zur Herstellung von beschichteten Kohlenstoffpartikeln, zeichnet sich dadurch aus, dass elektrisch leitfähige Kohlenstoffpartikel in einem Reaktionsraum durch chemische Gasphasenabscheidung aus zumindest einem gasförmigen Silan in einer sauerstofffreien Gasatmosphäre mit elementarem dotiertem oder undotiertem Silizium beschichtet werden, wobei die elektrisch leitfähigen Kohlenstoffpartikel während der Gasphasenabscheidung ständig in Bewegung sind.

Die elektrisch leitfähigen Kohlenstoffpartikel sind in dem erfindungsgemäßen Verfahren in dem Reaktionsraum ständig in Bewegung, um auf diese Weise eine gleichmäßige Beschichtung dieser Kohlenstoffpartikel zu erzielen. Dies kann beispielsweise durch den in den Reaktionsraum geleiteten Gasstrom erzielt werden. Hierbei wird die Reaktorgeometrie, insbesondere die Anordnung der Zuleitung des Gasstroms, und der Volumenstrom des eingeleiteten Gasstroms so gewählt, dass es zu einer Bewegung der elektrisch leitfähigen Kohlenstoffpartikel kommt. Beispielsweise kann somit das erfindungsgemäße Verfahren in einem Wirbelschichtreaktor durchgeführt werden. Eine weitere Möglichkeit ist die Durchführung der Gasphasenabscheidung in einem Drehrohrofen, um auf diese Weise eine Bewegung bzw. Durchmischung der Kohlenstoffpartikel zu erzwingen.

Die zu beschichtenden Kohlenstoffpartikel können in den Reaktionsraum entweder batchweise oder kontinuierlich zugeführt werden, ferner können auch die beschichteten Kohlenstoffpartikel entweder batchweise oder kontinuierlich aus dem Reaktionsraum abgeführt werden. Somit kann das erfindungsgemäße Verfahren batchweise oder kontinuierlich durchgeführt werden.

In dem erfindungsgemäßen Verfahren werden vorzugsweise elektrisch leitfähige Kohlenstoffpartikel, die amorph und/oder kristallin in Form des Graphits sind, eingesetzt, bevorzugt werden jedoch Graphitpartikel eingesetzt. Entscheidend für das erfindungsgemäße Verfahren ist der Einsatz von elektrisch leitfähigen Kohlenstoffpartikeln, die bevorzugt einen spezifischen Widerstand von maximal 10⁻² Ω cm aufweisen.

Vorzugsweise werden in dem erfindungsgemäßen Verfahren Kohlenstoffpartikel mit einer Reinheit von mindestens 97%, bevorzugt mit einer Reinheit von mindestens 98% und besonders bevorzugt von 99% eingesetzt. Insbesondere werden in dem erfindungsgemäßen Verfahren Kohlenstoffpartikel mit einem mittleren Partikeldurchmesser von 10 nm bis 44 µm, bevorzugt von 20 nm bis 15 µm eingesetzt. Vorteilhafterweise werden in dem erfindungsgemäßen Verfahren Graphitpartikel mit einem mittleren Partikeldurchmesser von 4 bis 10 µm eingesetzt. In dem erfindungsgemäßen Verfahren können auch Rußpartikel als Kohlenstoffpartikel eingesetzt werden, die sich aus Primärpartikeln zu Aggregaten und/oder Agglomeraten sich zusammengelagert haben, wobei die Primärpartikel hierbei vorzugsweise einen mittleren Partikeldurchmesser von 20 bis 60 nm aufweisen.

Unter Aggregate ist im Rahmen dieser Erfindung zu verstehen, dass sphärische oder weitestgehend sphärische Primärpartikel, wie sie zunächst in der Reaktion zur Herstellung der Rußpartikel gebildet werden, im weiteren Reaktionsverlauf zu Aggregaten zusammenwachsen. Der Verwachsungsgrad der Aggregate kann durch die Prozessparameter der Herstellung der Rußpartikel beeinflusst werden. Diese Aggregate können im weiteren Reaktionsverlauf Agglomerate bilden. Im Gegensatz zu den Aggregaten, die sich in der Regel nicht oder nur teilweise in die Primärpartikel zerlegen lassen, wird im Rahmen dieser Erfindung unter Agglomeraten eine nur lose Zusammenballung von Aggregaten, die leicht in die Aggregate zerfallen können, verstanden.

Im Sinne dieser Erfindung wird unter einem mittleren Partikeldurchmesser der d₅₀-Wert verstanden, d.h. ein mittlerer Partikeldurchmesser von 5 µm bedeutet, dass 50 % aller Partikel einen Partikeldurchmesser von kleiner oder gleich 5 µm haben. Es werden in dem erfindungsgemäßen Verfahren Kohlenstoffpartikel mit einer BET-Oberfläche von 5 bis 700 m²/g, bevorzugt von 6 bis 140 m²/g und besonders bevorzugt von 10 bis 50 m²/g eingesetzt. Die BET-Oberfläche wird gemäß dieser Erfindung nach ISO 9277 (1995), die die DIN 66131 ersetzt, ermittelt.

Bevorzugt wird in dem erfindungsgemäßen Verfahren Graphit als Kohlenstoffpartikel eingesetzt, wie er beispielsweise von der Firma Timcal unter dem Handelsnamen TIMREX vertrieben wird.

In einer besonderen Ausführungsform des erfindungsgemäßen Verfahrens werden Kohlenstoffpartikel eingesetzt, deren Oberfläche zuvor durch ein geeignetes Verfahren modifiziert worden sind. Dies kann beispielsweise durch ein Plasma, durch eine Ozonisierung oder durch ein naßchemisches Verfahren erfolgen. Die Modifizierung der in dem erfindungsgemäßen Verfahren eingesetzten Kohlenstoffpartikel kann entweder in einem weiteren Reaktor vor der Durchführung des erfindungsgemäßen Verfahrens durchgeführt werden oder in einem vorgeschaltenen Verfahrensschritt in derselben Beschichtungsanlage wie das erfindungsgemäße Verfahren durchgeführt werden.

Der in dem erfindungsgemäßen Verfahren in den Reaktionsraum eingeleitete Gasstrom weist vorzugsweise neben dem gasförmigen Silan und den ggf. gasförmigen Verbindungen der Dotierungselemente ein Trägergas auf. Als Trägergas können in dem erfindungsgemäßen Verfahren Helium, Neon, Wasserstoff, Stickstoff oder Argon, bevorzugt Wasserstoff, Stickstoff oder Argon und besonders bevorzugt Argon eingesetzt werden. Die sauerstofffreie Gasatmosphäre weist vorzugsweise das Trägergas, das Silan sowie die gasförmigen Verbindung der Dotierungselemente auf.

Vorzugsweise wird in dem erfindungsgemäßen Verfahren ein Gasstrom, enthaltend zumindest ein gasförmiges Silan und Argon, in den Reaktionsraum geleitet. Bevorzugt wird in dem erfindungsgemäßen Verfahren zumindest ein Silan, ausgewählt aus SiH₄, Si₂H₆, ClSiH₃, Cl₂SiH₂, Cl₃SiH und/oder SiCl₄, eingesetzt, besonders bevorzugt wird ein Gasstrom eingesetzt, der als gasförmiges Silan nur das Monosilan SiH₄ aufweist. In einer besonderen Ausführungsform des erfindungsgemäßen Verfahrens weist der eingesetzte Gasstrom eine Mischung von mehreren gasförmigen Silanen auf. Im Sinne dieser Erfindung werden unter Silanen Silizium-Wasserstoffverbindungen als auch Silizium-Chlor-Wasserstoffverbindungen und Silizium-Chlorverbindungen verstanden. Der in dem erfindungsgemäßen Verfahren eingesetzte Gasstrom weist vorzugsweise von 0,5 bis 100 Vol.-%, bevorzugt von 1 bis 90 Vol.-% und besonders bevorzugt von 5 bis 50 Vol.-% an gasförmigen Silan bezogen auf den in den Reaktionsraum geleiteten Gasstrom auf.

In einer besonderen Ausführungsform des erfindungsgemäßen Verfahrens weist der in den Reaktionsraum geleitete Gasstrom neben dem gasförmigen Silan gasförmige Verbindungen von Dotierungselementen, ausgewählt aus Phosphor, Arsen, Antimon, Bor, Aluminium, Gallium und/oder, Indium, auf. Besonders bevorzugt werden Diboran und Phosphan oder substituierte Phosphane, wie beispielsweise tBuPH₂, tBu₃P, tBuPh₂P oder tBuPh₂P und Trismethylaminophosphan ((CH₃)₂N)₃P eingesetzt. Vorzugsweise enthält der in den Reaktionsraum geleitete Gasstrom höchstens 1 Vol.-%, bevorzugt höchstens 0,1 Vol.-% an gasförmigen Verbindungen der Dotierungselemente.

In einer weiteren Ausführungsform des erfindungsgemäßen Verfahrens wird zusätzlich zu dem Silan eine verdampfbare lithiumorganische Verbindung, insbesondere Butyllithium, in den Reaktionsraum eingetragen. Vorteilhafterweise weist der eingeleitete Gasstrom mindestens 1 Vol.-% an der lithiumorganischen Verbindung auf.

In einer bevorzugten Ausführungsform des erfindungsgemäßen Verfahren wird in den Reaktionsraum ein Gasstrom einleitet, der aus einem Silan, besonders bevorzugt Monosilan, und einem Inertgas, besonders bevorzugt Argon, besteht. In einer weiteren Ausführungsform wird ein Gasstrom eingesetzt, der neben dem Silan und dem Inertgas zusätzlich noch eine gasförmige Verbindung eines Dotierungselements aufweist.

Die Verweilzeit des in den Reaktionsraum eingeleiteten Gasstroms wird vorzugsweise so gewählt, dass es möglichst zu einer quantitativen Umsetzung des Silans kommt. Die Verweilzeit beträgt daher in dem erfindungsgemäßen Verfahren vorzugsweise von 0,1 bis 10 Sekunden und bevorzugt von 1 bis 5 Sekunden.

Die Gasphasenabscheidung, bei der die eingesetzten gasförmigen Silane und ggf. der gasförmigen Verbindungen der Dotierungselemente und/oder lithiumorganischen Verbindungen zu elementaren dotiertem oder undotiertem Silizium zersetzt werden, wird bei dem erfindungsgemäßen Verfahren vorzugsweise bei einer Temperatur von 500°C bis 1400°C, bevorzugt von 600°C bis 1200°C und besonders bevorzugt von 630°C bis 1000°C durchgeführt. Das erfindungsgemäße Verfahren wird vorzugsweise bei einem Druck von 100 bis 1200 mbar und bevorzugt bei einem Druck von 500 bis 1200 mbar durchgeführt.

Die notwendige Energie zum Zersetzen des Silans in dem erfindungsgemäßen Verfahren kann zum einen über eine Wandheizung des Reaktionsraumes erfolgen, zum anderen kann dies auch über eine Mikrowellenheizung oder durch eine Bestrahlung mittels eines Laserlichtes erfolgen.

Die erfindungsgemäßen beschichteten Kohlenstoffpartikel zeichnen sich dadurch aus, dass elektrisch leitfähigen Kohlenstoffkern mit elementarem dotiertem oder undotiertem Silizium beschichtet ist. Vorzugsweise ist der erfindungsgemäß beschichtete Kohlenstoffpartikel durch das erfindungsgemäße Verfahren erhältlich.

Der elektrisch leitfähige Kohlenstoffkern des erfindungsgemäßen beschichteten Kohlenstoffpartikels ist vorzugsweise amorph und/oder kristallin in Form des Graphits, bevorzugt ist dieser kristallin in Form des Graphits. Der spezifische Widerstand des elektrisch leitfähigen Kohlenstoffkerns der erfindungsgemäßen beschichteten Kohlenstoffpartikel beträgt vorzugsweise maximal 10⁻² Ω cm.

Die erfindungsgemäßen beschichteten Kohlenstoffpartikel weisen vorzugsweise einen mittleren Partikeldurchmesser von 10 nm bis 65 µm, bevorzugt von 20 nm bis 25 µm. Besonders bevorzugt weisen erfindungsgemäße beschichtete Kohlenstoffpartikel, die einen elektrisch leitfähigen Kohlenstoffkern aus Ruß aufweisen, einen mittleren Partikeldurchmesser der Primärpartikel von 20 bis 90 nm auf. Erfindungsgemäße beschichtete Kohlenstoffpartikel mit einem elektrisch leitfähigen Kohlenstoffkern aus Graphit weisen besonders bevorzugt einen mittleren Partikeldurchmesser von 5 bis 15 µm auf. Die BET-Oberfläche der erfindungsgemäßen beschichteten Kohlenstoffpartikel beträgt von 5 bis 700 m²/g, bevorzugt von 6 bis 140 m²/g und besonders bevorzugt von 10 bis 50 m²/g. Die BET-Oberfläche wird gemäß dieser Erfindung nach ISO 9277 (1995), die die DIN 66131 ersetzt, ermittelt.

Die erfindungsgemäßen beschichteten Kohlenstoffpartikel weisen vorzugsweise von 4 bis 60 Gew.-%, bevorzugt von 5 bis 50 Gew.-% und besonders bevorzugt von 6 bis 40 Gew.-% an Silizium bezogen auf den beschichteten Kohlenstoffpartikel auf. Die Gewichtsprozent an Silizium werden gravimetrisch bestimmt, hierbei wird durch eine Verbrennungsanalyse der enthaltene Kohlestoff über das freiwerdende Kohlendioxid bestimmt.

Die Beschichtung aus elementarem Silizium der erfindungsgemäßen beschichteten Kohlenstoffpartikel weisen vorzugsweise Dotierungselemente, ausgewählt aus Phosphor, Arsen, Antimon, Bor, Aluminium, Gallium und/oder Indium, auf. Der Anteil dieser Dotierungselemente kann in der Beschichtung bis zu maximal 1 Atom-% betragen. In der Regel enthält die Beschichtung die Dotierungselemente im ppm oder gar ppb-Bereich. Bevorzugt ist ein Bereich von 10¹⁵ bis 10¹⁹ Atome Dotierungselemente/cm³.

Ebenfalls ist es möglich, dass die Beschichtung der erfindungsgemäßen beschichteten Kohlenstoffpartikel Lithium als Zusatzelement aufweist. Der Anteil des Lithiums in der Beschichtung kann entsprechend der höchstlithiierten Siliziumverbindung bis zu 50 Gew.-% betragen. Besonders bevorzugt können in der Beschichtung bis zu 20 bis 40 Gew.-% Lithium enthalten sein.

Das Dotierungselement und/oder Zusatzelement kann dabei homogen in der Beschichtung der erfindungsgemäßen Kohlenstoffpartikel verteilt sein, oder im Kohlenstoffkern angereichert oder interkaliert sein. Bevorzugt können die Dotierungselemente auf Gitterplätzen des Siliziums eingebaut sein. Dies ist im Wesentlichen von der Art der gasförmigen Verbindungen des Dotierungselements und der Reaktionsführung bei der Herstellung der beschichteten Kohlenstoffpartikel abhängig.

Weiterer Gegenstand der Erfindung ist die Verwendung der erfindungsgemäßen beschichteten Kohlenstoffpartikel oder der mittels dem erfindungsgemäßen Verfahren hergestellten beschichteten Kohlenstoffpartikel zur Herstellung von Anodenmaterial für Lithium-Ionenbatterien. Hierfür werden vorzugsweise die erfindungsgemäßen beschichteten Kohlenstoffpartikel mit einem Binder in einem Lösemittel suspendiert, wobei sich der Binder vorzugsweise löst. Hierfür kann es vorteilhaft sein, wenn die Suspension auf eine Temperatur unterhalb des Zersetzungspunktes des Binders und unterhalb des Siedepunktes des Lösemittels erwärmt wird.

Unter Elektrodenmaterial wird im Sinne dieser Erfindung ein Stoff oder eine Mischung aus zwei oder mehreren Stoffen verstanden, der/die es erlaubt, durch Oxidations- und/oder Reduktionsreaktionen elektrochemische Energie in einer Batterie zu speichern. Je nach dem, ob die elektrochemische Reaktion, welche, in der (geladenen) Batterie, Energie liefert eine Oxidation oder Reduktion ist, spricht man von negativem oder positivem Elektrodenmaterial oder auch von Anoden- oder Kathodenmaterial.

Die Suspension kann in einer Schichtdicke von 1 µm bis 500 µm, bevorzugt von 2 µm bis 100 µm auf einen Stromsammler, insbesondere auf eine Kupferfolie, aufgerakelt werden. Andere Beschichtungsverfahren können ebenso verwendet werden. Vor dem Beschichten des Stromsammlers mit der Suspension kann eine Behandlung des Stromsammlers mit einem handelsüblichen Primer, auf der Basis von Polymerharzen, erfolgen. Er erhöht die Haftung des Anodenmaterials auf dem Stromsammler, besitzt aber selbst praktisch keine elektrochemische Aktivität. Es können jedoch auch andere Haftvermittler verwendet werden oder man kann auf die Verwendung des Haftvermittlers gänzlich verzichten. In einer bevorzugten Ausführungsform erfolgt der Auftrag dieser Suspension direkt auf einen Stromsammler.

In einer besonderen Ausführungsform der erfindungsgemäßen Verwendung wird eine Zusammensetzung enthaltend oder bestehend aus
- 5 - 86 Gew.-% der erfindungsgemäßen beschichteten Kohlenstoffpartikel,
- 4 - 20 Gew.-% eines Bindemittels,
- 0 - 10 Gew.-% eines Leitfähigkeitsverbessers und
- 0 - 40 Gew.-% Graphit mit einem mittleren Partikeldurchmesser von 1 µm bis 100 µm
wobei die Anteile der Komponenten in Summe maximal 100 Gew.-% ergeben, in einem Lösemittel suspendiert und auf einen Stromsammler aufgerakelt. Vorzugsweise wird eine Zusammensetzung enthaltend oder bestehend aus
- 5 - 86 Gew.-% der erfindungsgemäßen beschichteten Kohlenstoffpartikel,
- 4 - 20 Gew.-% eines Bindemittels und
- 0 - 10 Gew.-% eines Leitfähigkeitsverbessers,
bevorzugt wird jedoch eine Zusammensetzung enthaltend oder bestehend aus
- 5 - 86 Gew.-% der erfindungsgemäßen beschichteten Kohlenstoffpartikel und
- 4 - 20 Gew.-% eines Bindemittels
in der erfindungsgemäßen Verwendung eingesetzt.

Als Leitfähigkeitsverbesserer wird in der erfindungsgemäßen Verwendung vorzugsweise ein Leitruß eingesetzt. Es kann vorteilhaft sein, wenn die Zusammensetzung in der erfindungsgemäßen Verwendung von 0 bis 5 Gew.-%, bevorzugt von 0,5 bis 4 Gew.-% an Leitruß aufweist. Vorzugsweise weist diese Zusammensetzung als Leitruß einen hochreinen synthetischen Ruß auf. Bevorzugt weist dieser einen mittleren Partikeldurchmesser von 20 bis 60 nm, besonders bevorzugt von 30 bis 50 nm auf. Vorteilhaft ist ferner, dass der in dieser Zusammensetzung enthaltene Leitruß eine BET-Oberfläche von 50 bis 80 m²/g, bevorzugt von 55 bis 70 m²/g aufweist. In einer besonderen Ausführungsform der erfindungsgemäßen Verwendung weist diese Zusammensetzung als Leitruß einen hochreinen synthetischen Ruß mit einem mittleren Partikeldurchmesser von 35 bis 45 nm und einer BET-Oberfläche von 57 bis 67 m²/g auf.

Ebenso kann es vorteilhaft sein, wenn diese Zusammensetzung von 4 bis 20 Gew.-%, bevorzugt von 5 bis 10 Gew.-% und besonders bevorzugt 10 Gew.-% an einem Bindemittel aufweist. Unter einem Bindemittel im Sinne dieser Erfindung wird eine chemische Verbindung verstanden, die in der Lage ist die Komponenten erfindungsgemäße beschichtete Kohlenstoffpartikel, Graphit und gegebenenfalls Leitruß untereinander und mit dem Stromsammler, das vorzugsweise aus Kupfer, Nickel oder Edelstahl besteht, zu verbinden. Vorzugsweise weist diese Zusammensetzung polymere Bindemittel, bevorzugt Polyvinylidenfluorid, Polytetrafluorethylen oder Polyolefine, besonders bevorzugt jedoch thermoplastische Elastomere, insbesondere Ethylen/Propylen-Dien-Terpolymere, auf. In einer besonderen Ausführungsform der erfindungsgemäßen Verwendung weist diese Zusammensetzung Gelatine oder modifizierte Zellulose als Bindemittel auf.

Die Zusammensetzung in der erfindungsgemäßen Verwendung weist vorzugsweise von 0 bis 40 Gew.-% an Graphit auf, der vorzugsweise einen mittleren Partikeldurchmesser von 1 bis 100 µm, bevorzugt von 2 bis 50 µm aufweist. Der in dieser Zusammensetzung enthaltene Graphit weist vorzugsweise einem d₉₀-Wert von 5 bis 10 µm auf. Im Sinne dieser Erfindung wird unter einem d₉₀-Wert von 6 µm verstanden, dass 90 % aller Partikel einen Partikeldurchmesser von kleiner oder gleich 6 µm haben. Der in der Zusammensetzung vorhandene Graphit weist vorzugsweise BET-Oberfläche vorzugsweise von 5 bis 30 m²/g, bevorzugt von 10 bis 20 m²/g auf.

Das erfindungsgemäße Anodenmaterial zeichnet sich dadurch aus, dass das Anodenmaterial erfindungsgemäße beschichtete Kohlenstoffpartikel aufweist. Vorzugsweise weist das erfindungsgemäße Anodenmaterial
- 5 - 86 Gew.-% der erfindungsgemäßen beschichteten Kohlenstoffpartikel,
- 4 - 20 Gew.-% eines Bindemittels
- 0 - 10 Gew.-% Leitfähigkeitsverbesserer und
- 0 - 40 Gew.-% Graphit mit einem mittleren Partikeldurchmesser von 1 µm bis 100 µm
auf, wobei die Anteile der Komponenten in Summe maximal 100 Gew.-% ergeben.

Als Leitfähigkeitsverbesserer weist das erfindungsgemäße Anodenmaterial vorzugsweise ein Leitruß auf. Es kann vorteilhaft sein, wenn das erfindungsgemäße Anodenmaterial von 0 bis 5 Gew.-%, bevorzugt von 0,5 bis 4 Gew.-% an Leitruß aufweist. Vorzugsweise weist das erfindungsgemäße Anodenmaterial als Leitruß einen hochreinen synthetischen Ruß. Bevorzugt weist dieser einen mittleren Partikeldurchmesser von 20 bis 60 nm, besonders bevorzugt von 30 bis 50 nm auf. Vorteilhaft ist ferner, dass der in dem erfindungsgemäßen Anodenmaterial enthaltene Leitruß eine BET-Oberfläche von 50 bis 80 m²/g, bevorzugt von 55 bis 70 m²/g aufweist. In einer besonderen Ausführungsform des erfindungsgemäßen Anodenmaterials weist dieses als Leitruß einen hochreinen synthetischen Ruß mit einem mittleren Partikeldurchmesser von 35 bis 45 nm und einer BET-Oberfläche von 57 bis 67 m²/g auf.

Ebenso kann es vorteilhaft sein, wenn das erfindungsgemäße Anodenmaterial von 4 bis 20 Gew.-%, bevorzugt von 5 bis 10 Gew.-% und besonders bevorzugt 10 Gew.-% an einem Bindemittel aufweist. Unter einem Bindemittel im Sinne dieser Erfindung wird eine chemische Verbindung verstanden, die in der Lage ist die Komponenten erfindungsgemäße beschichtete Kohlenstoffpartikel, Graphit und gegebenenfalls Leitruß untereinander und mit dem Stromsammler, das vorzugsweise aus Kupfer, Nickel oder Edelstahl besteht, zu verbinden. Vorzugsweise weist das erfindungsgemäße Anodenmaterial polymere Bindemittel, bevorzugt Polyvinylidenfluorid, Polytetrafluorethylen oder Polyolefine, besonders bevorzugt jedoch thermoplastische Elastomere, insbesondere Ethylen/Propylen-Dien-Terpolymere, auf. In einer besonderen Ausführungsform des erfindungsgemäßen Anodenmaterials weist dieses Gelatine oder modifizierte Zellulose als Bindemittel auf.

Das erfindungsgemäße Anodenmaterial weist vorzugsweise von 0 bis 40 Gew.-% an Graphit auf, der vorzugsweise einen mittleren Partikeldurchmesser von 1 bis 100 µm, bevorzugt von 2 bis 50 µm aufweist. Der in dem erfindungsgemäßen Anodenmaterial enthaltene Graphit weist vorzugsweise einem d₉₀-Wert von 5 bis 10 µm auf. Im Sinne dieser Erfindung wird unter einem d₉₀-Wert von 6 µm verstanden, dass 90 % aller Partikel einen Partikeldurchmesser von kleiner oder gleich 6 µm haben. Der in der Zusammensetzung vorhandene Graphit weist vorzugsweise eine eine BET-Oberfläche vorzugsweise von 5 bis 30 m²/g, bevorzugt von 10 bis 20 m²/g auf.

In einer besonders bevorzugten Ausführungsform des erfindungsgemäßen Anodenmaterials weist dieses
- 5 - 86 Gew.-% der erfindungsgemäßen beschichteten Kohlenstoffpartikel,
- 4 - 20 Gew.-% eines Bindemittels und
- 0 - 10 Gew.-% Leitruß
auf, ganz besonders bevorzugt weist das erfindungsgemäße Anodenmaterial
- 5 - 86 Gew.-% der erfindungsgemäßen beschichteten Kohlenstoffpartikel und
- 4 - 20 Gew.-% eines Bindemittels
auf, wobei die Anteile der Komponenten in Summe maximal 100 Gew.-% ergeben.

Des weiteren ist Gegenstand dieser Erfindung eine Lithium-Ionenbatterie, die sich dadurch auszeichnet, dass diese eine Anode aufweist, bestehend aus dem erfindungsgemäßen Anodenmaterial.

Vorzugsweise weist diese erfindungsgemäßen Lithium-Ionenbatterie als Elektrolyt eine Elektrolytzusammensetzung aus mindestens einem organischen Lösungsmittel, ausgewählt aus Ethylencarbonat, Dimethylcarbonat, Ethylmethylcarbonat, Diethylcarbonat, Propylencarbonat, Butylencarbonat, Methylpropylcarbonat, Butylmethylcarbonat und seine Isomere, 1,2-Dimethoxyethan, Tetrahydrofuran, 2-Methyltetrahydrofuran, Diethylenglycoldialkylester, Dioxolan, Propylenoxid, Dimethylsulfoxid, Dimethylformamid, Formamid, Nitromethan, gamma-Butyrolacton, Carbonsäurealkylester und/oder Methyllactat, und mindestens einem Alkali- oder Erdalkalimetallsalz als Leitsalz, ausgewählt aus LiPF₆, LiClO₄, LiAsF₆, LiBF₄, LiCF₃SO₃, LiN(CF₃SO₂)₂, LiN(SO₂CF₂CF₃)₂, LiSbF₆, LiAlCl₄, LiGaCl₄, LiCl, LiNO₃, LiSCN, LiO₃SCF₂CF₃, LiC₆F₅SO₃, LiO₂CCF₃, LiFSO₃, LiB(C₆H₅)₄, LiB(C₂Oa)₂, Lithiumfluoroalkylphosphate, auf. Die Konzentration des Leitsalzes beträgt vorzugsweise von 0,5 mol/l bis zur Löslichkeitsgrenze des entsprechenden Salzes, bevorzugt jedoch 1 mol/l. In einer besonderen Ausführungsform der erfindungsgemäßen Lithium-Ionenbatterie weist diese einen Elektrolyten auf, der mindestens 50 Gew.-%, bevorzugt mindestens 80 Gew.-% an einer ionischen Flüssigkeit aufweist. Besonders bevorzugt weist dieser Elektrolyt 0,5 bis 10 Gew.-% eines Filmbildners, wie beispielsweise Vinylencarbonat auf. Unter einer ionischen Flüssigkeit werden im Sinne dieser Erfindung Salze verstanden, die einen Schmelzpunkt von maximal 100°C aufweisen.

Die erfindungsgemäßen Lithium-Ionenbatterien können allerdings auch einen Elektrolyten aufweisen, der von 0,5 bis 10 Gew.-%, bevorzugt von 2 bis 5 Gew.-% Vinylencarbonat aufweist.

Bevorzugt weist die erfindungsgemäße Lithium-Ionenbatterien einen Elektrolyten auf, der von 20 bis 70 Vol.-% an Ethylencarbonat und/oder 20 bis 70 Vol.-% Dimethylcarbonat, 0,5 bis 2 mol/l LiPF₆ und einen Zusatz von 0,5 bis 5 Gew.-% Vinylencarbonat aufweist. Besonders bevorzugt weist die erfindungsgemäße Lithium-Ionenbatterie einen Elektrolyten auf, der Propylencarbonat mit von 0,5 bis 2 mol/l LiPF₆ und einen Zusatz von 0,5 bis 5 Gew.-% Vinylencarbonat aufweist.

Als Kathode weisen die erfindungsgemäße Lithium-Ionenbatterie Kathoden gemäß dem Stand der Technik auf.

Die nachfolgenden Beispiele sollen die erfindungsgemäßen beschichteten Kohlenstoffpartikel sowie deren erfindungsgemäße Verwendung im Anodenmaterial näher erläutern, ohne dass die Erfindung auf diese Ausführungsform beschränkt sein soll.

### Beispiel 1 - Herstellung der erfindungsgemäßen beschichteten Kohlenstoffpartikel

In einem beheizbaren Drehrohrofen wurden 20 g Graphit (TIMREX KS6 der Fa. Timcal) vorgelegt. Der Ofen wurde auf eine Temperatur von 700°C aufgeheizt. Der rohrförmige Reaktionsraum mit dem vorgelegten Graphit wurde mit einer Umdrehungsgeschwindigkeit von 5 Umdrehungen pro Minute gedreht. Der Reaktionsraum des Drehrohrofens wurde von einem Gasstrom bestehend aus Argon als Trägergas und 10 Vol.-% Monosilan (SiH₄) mit einem Durchfluss von 50 sccm (standard cubic centimeters per minute; 1 sccm entspricht 1 cm³ Gas pro Minute bezogen auf 0°C und Atmosphärendruck) durchströmt. Nach einer Reaktionszeit von 4 Stunden erhält man beschichtete Kohlenstoffpartikel, die eine Beschichtung aus elementarem Silizium aufweisen.

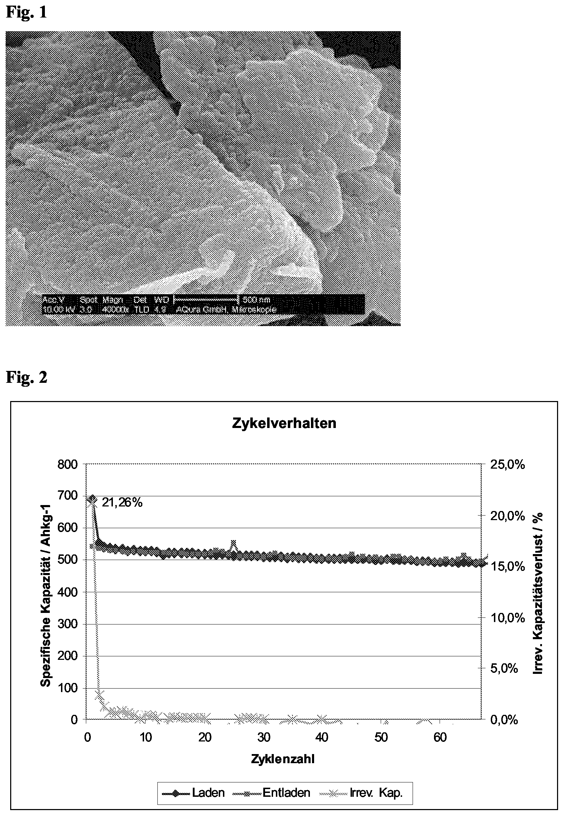

Die gravimetrische Analyse ergab, dass die beschichteten Kohlenstoffpartikel 7 Gew.-% an Silizium bezogen auf den beschichteten Kohlenstoffpartikel aufweisen. Eine REM-Aufnahme eines beschichteten Kohlenstoffpartikels zeigt die Fig. 1.

### Beispiel 2 - Herstellung des erfindungsgemäßen Anodenmaterials

- 90 g der gemäß Beispiel 1 hergestellten beschichteten Kohlenstoffpartikel und
- 10 g des Bindemittels Polyvinylidenfluorid (PVdF)
wurden zunächst mechanisch gemischt, anschließend in einer N-Methyl-2-pyrrolidon-Suspension, wobei das PVdF als 5 Gew.-%ige Lösung in N-Methyl-2-pyrollidon vorliegt, mittels eines Hochgeschwindigkeitsrührers ein weiteres Mal gemischt und anschließend auf eine mit einem Primer vorbehandelte 20 µm dicke handelsübliche Kupferfolie aufgerakelt, in einer Dicke von vorzugsweise 250 µm. Die auf diese Weise beschichtete Kupferfolie wird anschließend bei 80°C unter Vakuum getrocknet und anschließend bei ca. 80°C gewalzt. Die Elektroden wurden anschließend kreisförmig aus dieser beschichteten Kupferfolie ausgestanzt.

Die Behandlung der Kupferfolie vor dem Beschichten mit dem erfindungsgemäßen Elektrodenmaterial erfolgte mit einem handelsüblichen Primer, auf der Basis von Polymerharzen. Er erhöht die Haftung auf dem Kupfer, besitzt aber selbst praktisch keine elektrochemische Aktivität. Als Primer wurde der "Haftvermittler Conti Plus" von der Firma ContiTech eingesetzt. Er ist ein schwermetallfreier Polymerkleber auf Polychloropren-Basis. Er wird in einer Schichtdicke von 5 bis 30 µm aufgetragen.

### Beispiel 3 - Durchführung der elektrochemischen Untersuchungen

Das elektrochemische Zyklen fand in der sogenannten Halbzellenanordnungen statt. Bei der Halbzellenanordnung wird das erfindungsgemäße Anodenmaterial als Arbeitselektrode in einer Sandwich-Anordnung Arbeitselektrode - Separator/Elektrolyt - Gegen-/Referenzelektrode gemessen, wobei als Gegen-/Referenzelektrode eine Lithiumscheibe verwendet wurde. Als Potentialgrenzen wurden 100 mV und 1,0 V vs. Li/Li⁺ verwendet. Die Zyklengeschwindigkeit wird mit der Stromdichte pro aktive Masse - dies entspricht der Gesamtmasse an beschichteten Kohlenstoffpartikeln - des Anodenmaterials angegeben.

Das Laden erfolgte mit einer Stromabsenkung beim Erreichen der Spannungsgrenze bis unter einen Wert, der 10 mA/g entspricht. Die Verwendung dieser Stromabsenkung ermöglicht, die Leistungsfähigkeit einer Elektrode (Anteil des Stroms, der im Konstantstrommodus, oder galvanostatischen Anteil, fließt) von eventuellen irreversiblen Schäden (die sich in einer Verringerung der gesamten, also einschließlich der im potentiostatischen Schritt fließenden, Kapazität) zu trennen (siehe hierzu H. Buqa et al. in ITE Battery Letters, 4 (2003), 38).

Die elektrochemischen Untersuchungen wurden klassisch durchgeführt, d.h. mit einem ausschließlich auf die oberen und unteren Potentialgrenzen basierten Abschaltmodus für die einzelnen Halbzyklen. Dies ist der bei allen gängigen Batterien verwendete Modus.

Bei den elektrochemischen Untersuchungen wurden 0,5 mL eines Elektrolyten eingesetzt, der sich aus
- 98 Gew.-% einer Mischung aus 50 Gew.-% Ethylencarbonat und 50 Gew.-% Dimethylcarbonat, die 1 mol/l LiPF₆ bezogen auf die Mischung aufweist, und
- 2 Gew.-% Vinylencarbonat
zusammensetzt.

Die Fig. 2 zeigt die Ergebnisse der elektrochemischen Untersuchung (gezykelt wurde mit 50 mAh/g). Der sogenannte irreversible Kapazitätsverlust beträgt zu Beginn des Zyklens ca. 21 % und ist danach sehr niedrig. Das Fading beträgt beispielsweise 1,6 ‰ zwischen Zyklus 11 und 20. Unter Fading wird im Rahmen dieser Erfindung die Abnahme der reversiblen (nutzbaren) Kapazität mit zunehmender Zyklenzahl verstanden. Die irreversible Kapazität liegt schnell bei einem Wert von 0,2 bis 0,3 %. Die elektrochemische Kapazität beträgt ca. 2000 mAh/g. Die kumulierten irreversiblen Kapazitätsverluste der ersten 10 Zyklen betragen lediglich 29 %. Durch die Verwendung des erfindungsgemäßen beschichteten Kohlenstoffpartikel in dem Anodenmaterial lassen sich die Zykleneigenschaften verbessern und auch die mechanische Stabilität des Anodenmaterial nach häufigen Zyklen ist verbessert.

## Patentansprüche

1. Verfahren zur Herstellung von beschichteten Kohlenstoffpartikeln,
**dadurch gekennzeichnet,**
**dass** elektrisch leitfähige Kohlenstoffpartikel,
in einem Reaktionsraum durch chemische Gasphasenabscheidung aus zumindest einem gasförmigen Silan in einer sauerstofffreien Gasatmosphäre mit elementarem dotiertem oder undotiertem Silizium beschichtet werden,
wobei die elektrisch leitfähigen Kohlenstoffpartikel während der Gasphasenabscheidung ständig in Bewegung sind, und wobei Kohlenstoffpartikel mit einer BET-Oberfläche von 5 bis 700 m²/g eingesetzt werden.

2. Verfahren gemäß Anspruch 1,
**dadurch gekennzeichnet,**
**dass** die Kohlenstoffpartikel amorph und/oder kristallin in Form des Graphits sind.

3. Verfahren gemäß Anspruch 1 oder 2,
**dadurch gekennzeichnet,**
**dass** Kohlenstoffpartikel mit einem mittleren Partikeldurchrnesser von 10 nm bis 44 µm eingesetzt werden.

4. Verfahren gemäß zumindest einem der Ansprüche 1 bis 3,
**dadurch gekennzeichnet,**
**dass** als Kohlenstoffpartikel Graphitpartikel eingesetzt werden.

5. Verfahren gemäß zumindest einem der Ansprüche 1 bis 4,
**dadurch gekennzeichnet,**
**dass** ein Gasstrom, enthaltend zumindest ein gasförmiges Silan und Argon, in den Reaktionsraum geleitet wird.

6. Verfahren gemäß zumindest einem der Ansprüche 1 bis 5,
**dadurch gekennzeichnet,**
**dass** der Gasstrom von 5 bis 50 Vol.-% an gasförmigen Silan aufweist.

7. Verfahren gemäß zumindest einem der Ansprüche 1 bis 6,
**dadurch gekennzeichnet,**
**dass** der Gasstrom neben dem gasförmigen Silan gasförmige Verbindungen von Dotierungselementen, ausgewählt aus Phosphor, Arsen, Antimon, Bor, Aluminium, Gallium und/oder Indium, aufweist.

8. Verfahren gemäß zumindest einem der Ansprüche 1 bis 7,
**dadurch gekennzeichnet,**
**dass** der Gasstrom als gasförmiges Silan nur Monosilan SiH₄ aufweist.

9. Verfahren gemäß zumindest einem der Ansprüche 1 bis 8,
**dadurch gekennzeichnet,**
**dass** die Zersetzung des gasförmigen Silans und der gasförmigen Verbindung der Dotierungselemente zu elementarem dotiertem oder undotiertem Si bei einer Temperatur von 500 bis 1400°C durchgeführt wird.

10. Beschichteter Kohlenstoffpartikel,
**dadurch gekennzeichnet,**
**dass** ein elektrisch leitfähiger Kohlenstoffkern mit elementarem dotiertem oder undotiertem Silizium beschichtet ist, wobei die BET-Oberfläche des beschichteten Kohlenstoffpartikels 5 bis 700 m²/g beträgt.

11. Beschichteter Kohlenstoffpartikel gemäß Anspruch 10,
**dadurch gekennzeichnet,**
**dass** der elektrisch leitfähige Kohlenstoff-Kern amorph und/oder kristallin in Form des Graphits ist.

12. Beschichteter Kohlenstoffpartikel gemäß Anspruch 11,
**dadurch gekennzeichnet,**
**dass** der beschichtete Partikel einen mittleren Partikeldurchmesser von 10 nm bis 65 µm aufweist.

13. Beschichteter Kohlenstoffpartikel gemäß Anspruch 10 oder 12,
**dadurch gekennzeichnet,**
**dass** der beschichtete Partikel von 4 bis 60 Gew.-% an Silizium bezogen auf den beschichteten Kohlenstoffpartikel aufweist.

14. Beschichteter Kohlenstoffpartikel gemäß zumindest einem der Ansprüche 10 bis 13,
**dadurch gekennzeichnet,**
**dass** die Beschichtung aus elementarem Silizium Dotierungselemente, ausgewählt aus Phosphor, Arsen, Antimon, Bor, Aluminium, Gallium und/oder Indium, aufweist.

15. Verwendung der beschichteten Kohlenstoffpartikel gemäß zumindest einem der Ansprüche 10 bis 14 zur Herstellung von Anodenmaterial für Lithium-Ionenbatterien.

16. Anodenmaterial für Lithium-Ionenbatterien,
**dadurch gekennzeichnet,**
**dass** das Anodenmaterial beschichtete Kohlenstoffpartikel gemäß zumindest einem der Ansprüche 10 bis 14 aufweist.

17. Anodenmaterial gemäß Anspruch 16,
**dadurch gekennzeichnet,**
**dass** das Anodenmaterial
• 5 - 86 Gew.-% der beschichteten Kohlenstoffpartikel gemäß zumindest einem der Ansprüche 9 bis 12,
• 4 - 20 Gew.-% eines Bindemittels,
• 10 Gew.-% Leitfähigkeitsverbesserer und
• 40 Gew.-% Graphit mit einem mittleren Partikeldurchmesser von 1 µm bis 100 µm aufweist, wobei die Anteile der Komponenten in Summe maximal 100 Gew.-% ergeben.

18. Anodenmaterial gemäß Anspruch 16 oder 17,
**dadurch gekennzeichnet,**
**dass** das Anodenmaterial
• 5 - 86 Gew.-% der beschichteten Kohlenstoffpartikel gemäß zumindest einem der Ansprüche 10 bis 14,
• 4 - 20 Gew.-% eines Bindemittels und
• 10 Gew.-% Leitfähigkeitsverbesserer
aufweist, wobei die Anteile der Komponenten in Summe maximal 100 Gew.-% ergeben.

19. Lithium-Ionenbatterie,
**dadurch gekennzeichnet,**
**dass** diese eine Anode bestehend aus einem Anodenmaterial gemäß zumindest einem der Ansprüche 16 bis 18 aufweist.

## Claims

1. A process for producing coated carbon particles, **characterized in that** electrically conductive carbon particles are coated with elemental doped or undoped silicon in a reaction space by chemical vapor deposition of at least one gaseous silane in an oxygen-free gas atmosphere,
wherein the electrically conductive carbon particles are constantly in motion during the vapor deposition and wherein carbon particles having a BET surface area of from 5 to 700 m²/g are used.

2. The process according to claim 1, **characterized in that** the carbon particles are amorphous and/or crystalline in the form of graphite.

3. The process according to claim 1 or 2, **characterized in that** carbon particles having an average particle diameter of from 10 nm to 44 µm are used.

4. The process according to at least one of claims 1 to 3, **characterized in that** graphite particles are used as carbon particles.

5. The process according to at least one of claims 1 to 4, **characterized in that** a gas stream comprising at least one gaseous silane and argon is passed into the reaction space.

6. The process according to at least one of claims 1 to 5, **characterized in that** the gas stream comprises from 5 to 50% by volume of gaseous silane.

7. The process according to at least one of claims 1 to 6, **characterized in that** the gas stream in addition to the gaseous silane comprises gaseous compounds of doping elements selected from phosphorus, arsenic, antimony, boron, aluminum, gallium and/or indium.

8. The process according to at least one of claims 1 to 7, **characterized in that** the gas stream comprises only monosilane SiH₄ as the gaseous silane.

9. The process according to at least one of claims 1 to 8, **characterized in that** the decomposition of the gaseous silane and the gaseous compound of the doping elements into elemental doped or undoped Si is carried out at a temperature of from 500 to 1400°C.

10. A coated carbon particle, **characterized in that**
an electrically conductive carbon core is coated with elemental doped or undoped silicon, wherein the BET surface area of the coated carbon particle is from 5 to 700 m²/g.

11. The coated carbon particle according to claim 10, **characterized in that** the electrically conductive carbon core is amorphous and/or crystalline in the form of graphite.

12. The coated carbon particle according to claim 11, **characterized in that** the coated particle has an average particle diameter of from 10 nm to 65 µm.

13. The coated carbon particle according to claim 10 or 12, **characterized in that** the coated particle comprises from 4 to 60% by weight of silicon, based on the coated carbon particle.

14. The coated carbon particle according to at least one of claims 10 to 13, **characterized in that**
the coating of elemental silicon comprises doping elements selected from phosphorus, arsenic, antimony, boron, aluminum, gallium and/or indium.

15. Use of the coated carbon particles according to at least one of claims 10 to 14 for producing an anode material for lithium-ion batteries.

16. An anode material for lithium-ion batteries, **characterized in that** the anode material comprises coated carbon particles according to at least one of claims 10 to 14.

17. The anode material according to claim 16, **characterized in that** the anode material comprises
• from 5 to 86% by weight of the coated carbon particles according to at least one of claims 9 to 12,
• from 4 to 20% by weight of a binder,
• 10% by weight of a conductivity improver,
• 40% by weight of graphite having an average particle diameter of from 1 µm to 100 µm, wherein the proportions of the components add up to a maximum of 100% by weight.

18. The anode material according to claim 16 or 17, **characterized in that** the anode material comprises
• from 5 to 86% by weight of the coated carbon particles according to at least one of claims 10 to 14,
• from 4 to 20% by weight of a binder and
• 10% by weight of a conductivity improver,
wherein the proportions of the components add up to a maximum of 100% by weight.

19. Lithium-ion battery, **characterized in that**
it comprises an anode consisting of an anode material according to at least one of claims 16 to 18.

## Revendications

1. Procédé de fabrication de particules de carbone revêtues,
**caractérisé en ce que** des particules de carbone électriquement conductrices sont revêtues de silicium élémentaire dopé ou non dopé sous une atmosphère gazeuse dépourvue d'oxygène à partir d'au moins un silane gazeux par dépôt chimique en phase gazeuse dans une chambre de réaction,
dans lequel les particules de carbone électriquement conductrices sont constamment en mouvement pendant le dépôt en phase gazeuse, et dans lequel des particules de carbone ayant une surface BET de 5 à 700 m²/g sont mises en oeuvre.

2. Procédé selon la revendication 1, **caractérisé en ce que** les particules de carbone sont amorphes et/ou cristallines sous la forme de graphite.

3. Procédé selon la revendication 1 ou 2, **caractérisé en ce que** des particules de carbone ayant un diamètre moyen de particule de 10 nm à 44 µm sont mises en oeuvre.

4. Procédé selon au moins l'une des revendications 1 à 3, **caractérisé en ce que** des particules de graphite sont mises en oeuvre en tant que particules de carbone.

5. Procédé selon au moins l'une des revendications 1 à 4, **caractérisé en ce qu'**un courant gazeux contenant au moins un silane gazeux et de l'argon est introduit dans la chambre de réaction.

6. Procédé selon au moins l'une des revendications 1 à 5, **caractérisé en ce que** le courant gazeux présente 5 à 50 % en volume de silane gazeux.

7. Procédé selon au moins l'une des revendications 1 à 6, **caractérisé en ce que** le courant gazeux présente, hormis le silane gazeux, des composés gazeux d'éléments de dopage, choisis parmi le phosphore, l'arsenic, l'antimoine, le bore, l'aluminium, le gallium, et/ou l'indium.

8. Procédé selon au moins l'une des revendications 1 à 7, **caractérisé en ce que** le courant gazeux présente comme silane gazeux seulement du monosilane SiH₄.

9. Procédé selon au moins l'une des revendications 1 à 8, **caractérisé en ce que** la décomposition du silane gazeux et du composé gazeux des éléments de dopage en Si élémentaire dopé ou non dopé est réalisée à une température de 500 à 1400 °C.

10. Particule de carbone revêtue, **caractérisée en ce qu'**un noyau de carbone électriquement conducteur est revêtu de silicium élémentaire dopé ou non dopé, dans laquelle la surface BET de la particule de carbone revêtue est de 5 à 700 m²/g.

11. Particule de carbone revêtue selon la revendication 10, **caractérisée en ce que** le noyau de carbone électriquement conducteur est amorphe et/ou cristallin sous forme de graphite.

12. Particule de carbone revêtue selon la revendication 11, **caractérisée en ce que** la particule revêtue présente un diamètre moyen de particules de 10 nm à 65 µm.

13. Particule de carbone revêtue selon la revendication 10 ou 12, **caractérisée en ce que** la particule revêtue présente de 4 à 60 % en poids de silicium par rapport à la particule de carbone revêtue.

14. Particule de carbone revêtue selon au moins l'une des revendications 10 à 13, **caractérisée en ce que** le revêtement en silicium élémentaire présente des éléments de dopage choisis parmi le phosphore, l'arsenic, l'antimoine, le bore, l'aluminium, le gallium, et/ou l'indium.

15. Utilisation des particules de carbone revêtues selon au moins l'une des revendications 10 à 14 pour la fabrication de matière anodique pour des batteries lithium - ions.

16. Matière anodique pour des batteries lithium - ions, **caractérisée en ce que** la matière anodique présente des particules de carbone revêtues selon au moins l'une des revendications 10 à 14.

17. Matière anodique selon la revendication 16, **caractérisée en ce que** la matière anodique comprend
• 5 à 86 % en poids de particules de carbone revêtues selon au moins l'une des revendications 9 à 12,
• 4 à 20 % en poids d'un liant,
• 10 % en poids d'un améliorant de conductivité et
• 40 % en poids de graphite ayant un diamètre moyen de particules de 1 µm à 100 µm, dans laquelle les proportions des composants donnent au total au maximum 100 % en poids.

18. Matière anodique selon la revendication 16 ou 17, **caractérisée en ce que** la matière anodique comprend
• 5 à 86 % en poids de particules de carbone revêtues selon au moins l'une des revendications 10 à 14,
• 4 à 20 % en poids d'un liant et
• 10 % en poids d'un améliorant de conductivité,
dans laquelle les proportions des composants donnent au total au maximum 100 % en poids.

19. Batterie lithium - ions, **caractérisée en ce que** celle-ci présente une anode constituée d'une matière anodique selon au moins l'une des revendications 16 à 18.
